# EUROPÄISCHE PATENTSCHRIFT

(11) **EP 1 110 094 B1**
(45) Veröffentlichungstag und Bekanntmachung des Hinweises auf die Patenterteilung: **20.11.2002**
(21) Anmeldenummer: 99946002.5
(22) Anmeldetag: 20.08.1999
(51) Int. Cl.: G01R 15/20, G01R 33/022

(54) **VORRICHTUNG UND VERFAHREN ZUR BILDUNG EINES ODER MEHRERER MAGNETFELDGRADIENTEN DURCH EINEN GERADEN LEITER**
DEVICE AND METHOD FOR CREATING ONE OR MORE MAGNETIC FIELD GRADIENTS THROUGH A STRAIGHT CONDUCTOR
DISPOSITIF ET PROCEDE DE FORMATION D'AU MOIS UN GRADIENT DE CHAMP MAGNETIQUE AU TRAVERS D'UN CONDUCTEUR RECTILIGNE

(30) Priorität: 25.08.1998 DE 19838536
(43) Veröffentlichungstag der Anmeldung: 27.06.2001
(73) Patentinhaber: Lust Antriebstechnik GmbH, 35633 Lahnau (DE)
(72) Erfinder: KUNZE, Jürgen, D-35585 Wetzlar (DE); SCHEPP, Gunther, D-35428 Langgöns-Oberkleen (DE); WEBER, Jan, Thorsten, D-49525 Lengerich (DE)
(74) Vertreter: Knefel, Cordula, Dipl.-Phys.
(86) Internationale Anmeldenummer: EP9906109
(87) Internationale Veröffentlichungsnummer: WO00011482

(56) Entgegenhaltungen:
- EP-A- 0 061 520
- DE-U- 29 812 531
- US-A- 5 180 970
- US-A- 5 451 865

## Beschreibung

Die Erfindung betrifft eine Vorrichtung und ein Verfahren zur Bildung eines oder mehrerer Magnetfeldgradienten durch einen am Orte der Magnetfeldmessung geraden Stromleiter.
Der oder die entstandenen Magnetfeldgradienten sollen vorzugsweise zur potentialfreien Messung des Stromes in dem angesprochenen, am Orte der Magnetfeldmessung vorzugsweise gerade ausgeführten Leiters herangezogen werden.

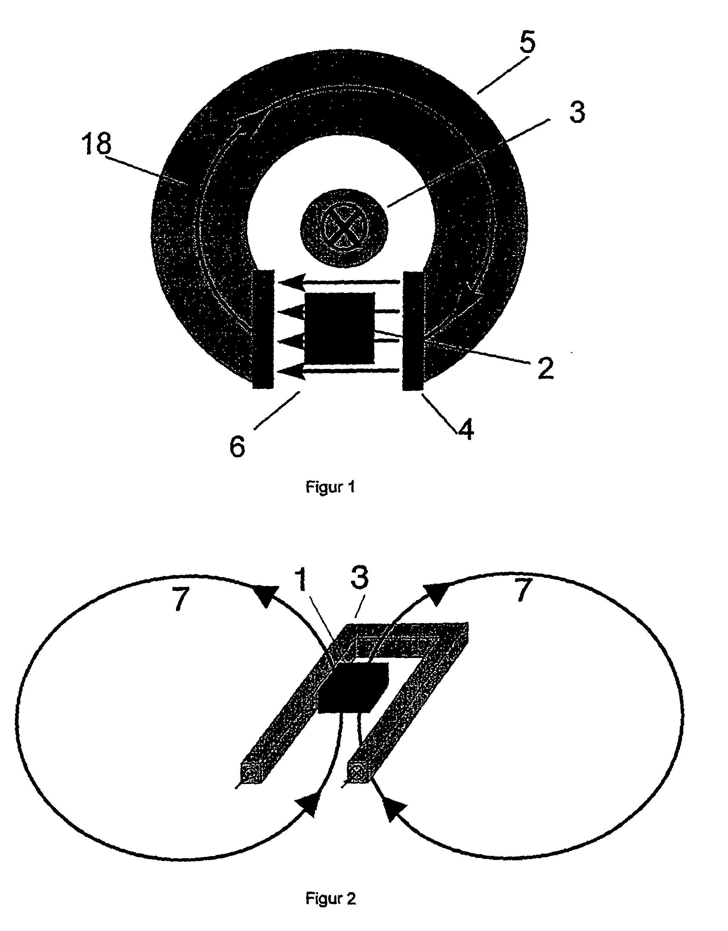

Es ist bekannt, Ströme potentialfrei durch die Aufzeichnung ihres Magnetfeldes mit Hilfe des Hall-Effektes zu messen (Proceedings PCIM Hongkong, Oktober 1997, S. 129 ff.) Die derzeit handelsüblichen Hall-Wandler benötigen allerdings relativ teure und insbesondere bei der Messung höherer Ströme auch voluminöse Eisen- oder Ferritkerne zur Konzentration des magnetischen Flusses auf die magnetfeldempfindlichen Bereiche des jeweiligen Wandlers (Figur 1).

Dieser Umstand, der auf die geringe Magnetfeldempfindlichkeit der erwähnten handelsüblichen Hall-Wandler zurückzuführen ist, hat zur Entwicklung empfindlicherer Hall-Wandler und anderer Magnetfeldmeßgeräte geführt.

So sind im Bereich der Hall-Wandler oder -Sensoren Vorrichtungen bekannt, die auf einem wenigen Quadratmillimeter großen Siliziumsubstrat sowohl eine magnetfeldempfindliche Schicht als auch Flußkonzentratoren enthalten [EPFL/Sentron, Higly Sensitive Hall Sensor, Auslage Hannover Messe Industrie, 1998 und H. Blanchard et al, Cylindrical Hall Device, Proc. International Electron Devices Meeting (IEDM '96), San Francisco, USA, Dec. 8-11, 1996].

Darüber hinaus gibt es eine ganze Reihe weiterer Verfahren zur Magnetfeldmessung, die aufgrund ihrer Empfindlichkeit auch ohne Eisen- oder Ferritkerne für die potentialfreie Strommessung geeignet sind.

So sind seit längerer Zeit Magnetfeldmeßgeräte bekannt, die auf der Basis magnetoresistiver Effekte wie des anisotropen magnetoresistiven Effektes (AMR) (Magnetoresistive Sensoren III, Abschlußbericht des Verbundprojektes IMOMAG, BMFT-Förderkennzeichen 13 MV 0109 - 0120, Kapitel 6.1, Magnetfeldsensor mit integrierter Kompensationsleitung MSK 6) oder des gigantischen magnetoresistiven Effektes (GMR) (Magnetoresistive Sensoren IV, Symposium und Statusseminar am 11. und 12. März 1997 in Wetzlar, Kapitel "MR-Sensoren mit Giantwiderstandsmaterialien: Potenzen und Probleme") arbeiten bekannt.

Darüber hinaus erscheint es in Zukunft auch denkbar, derartige Sensorsysteme auf der Basis des kolossalen magnetoresistiven Effektes (CMR) herzustellen (ebenda S. 7 f.).

Allen Sensorsystemen, die über eine magnetische Empfindlichkeit verfügen, die es ihnen gestattet, ohne Verwendung von voluminösen Eisenkernen Ströme potentialfrei zu messen, ist jedoch eine große Empfindlichkeit gegenüber Störfeldern eigen. Diesem Umstand wird gegenwärtig beispielsweise dadurch begegnet, daß durch eine spezielle Anordnung der magnetoresistiven Materialien, die in dem jeweiligen Meßgerät zum Einsatz kommen, Magnetfeldgradiometer hergestellt werden, die eine geringere Empfindlichkeit gegenüber homogenen Störfeldern aufweisen.

So beschreibt beispielsweise die DE 43 00 605 C2 einen Sensorchip, der insbesondere auf der Basis des AMR funktioniert und in der Lage ist, Strom durch die Aufzeichnung des Magnetfeldgradienten potentialfrei zu messen. Natürlich sind auch Vorrichtungen bekannt, die auf der Basis des GMR (Magnetoresistive Sensoren IV, Symposium und Statusseminar am 11. und 12. März 1997 in Wetzlar, Kapitel "MR-Sensoren mit Giantwiderstandsmaterialien: Potenzen und Probleme" S. 4 ff.) oder anderer magnetfeldempfindlicher Effekte arbeiten und als Gradiometer ausgelegt sind.

Auch die oben bereits vorgestellten, besonders empfindlichen Hall-Sensoren mit integrierten weichmagnetischen Flußkonzentratoren (EPFL/Sentron, Higly Sensitive Hall Sensor, Auslage Hannover Messe Industrie, 1998) sind prinzipiell auch als Gradiometer auslegbar. Zu diesem Zweck bedarf es lediglich der Aufbringung beispielsweise zweier magnetfeldempfindlicher Bereiche auf einem Siliziumsubstrat und der geeigneten Auswertung der beiden entstehenden Hall-Spannungen.

Ein Nachteil des beschriebenen Prinzips liegt in dem Umstand, einen Magnetfeldgradienden bereitstellen zu müssen, begründet.

Die DE 43 00 605 C2 und die US 5,548,208 schlagen zu diesem Zweck beispielsweise die U-förmige Ausführung des Stromleiters, durch den der zu messende Primärstrom geführt wird, vor (Figur 2). Das eigentliche Magnetfeldgradiometer wird bei diesen beiden Veröffentlichungen vorzugsweise auf einem potentialtrennenden Trägermaterial aufgebracht, das seinerseits auf dem U-förmigen Primärleiter befestigt wird.

Die Nachteile dieses Prinzips liegen jedoch auf der Hand: Es ist notwendig, den normalerweise in geraden Stromleitern fließenden Strom durch einen U-förmigen Primärleiter zu führen. Zu diesem Zweck werden insbesondere im Hochstrombereich massive Stromleiter oder Breitbandkabel unterbrochen und die Leiterenden in geeigneter Form mit den Anschlüssen des U-förmigen Primärleiters verbunden. Dieses Verfahren ist relativ aufwendig und vor allem mit den üblicherweise im Maschinen- und Fahrzeugbau verwendeten Fertigungsprozessen schwer vereinbar.

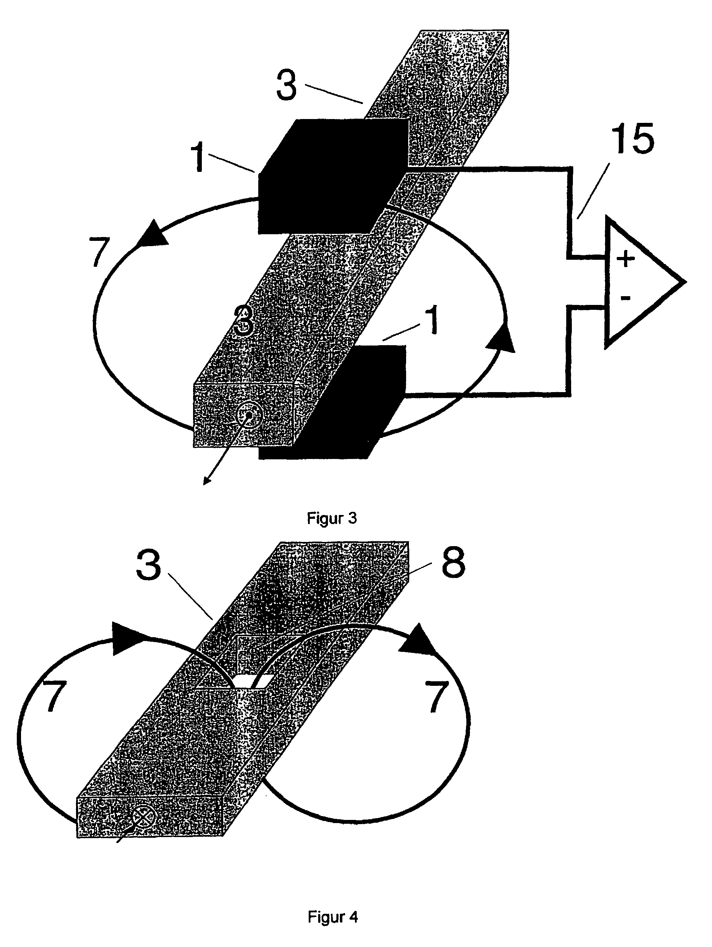

Daher ist auch eine Anordnung bekannt, die unter Verwendung mindestens zweier Magnetfeldmeßgeräte eine gegen homogene Störfelder relativ unempfindliche Strommessung ohne voluminöse Eisen- oder Ferritkerne erlaubt: Bei der DE 44 34 417 A1 werden insbesondere zwei Absolutfeldmeßgeräte auf vorzugsweise gegenüberliegenden Seiten eines geraden Leiters (parallel zur Stromflußrichtung) angeordnet (Figur 3). Auf diese Weise wird sichergestellt, daß das kreisförmige Magnetfeld des geraden Leiters die beiden Meßgeräte in umgekehrter Richtung durchsetzt. Die Ausgangssignale beider Meßgeräte werden voneinander subtrahiert, so daß die Störanteile homogener Störfelder weitgehend wegfallen.

Doch auch diese Erfindung weist immanente Nachteile auf. Zunächst sind gegenüber dem dargestellten gradiometrischen Prinzip zwei Magnetfeldmeßgeräte und zwei potentialtrennende Trägersubstrate zu verwenden. Darüber hinaus ist der Abstand zwischen den beiden Magnetfeldmeßgeräten nicht frei wählbar, da er insbesondere vom Durchmesser des Primärleiters abhängt.

Dieser Abstand ist jedoch für die Empfindlichkeit der Anordnung gegenüber Störfeldern entscheidend, da sich Störfelder natürlich mit dem Abstand verändern. Mit einfachen mathematischen Mitteln, wie der Subtraktion, sind die Einflüsse dieser Störfelder bei der Auswertung der Ausgangssignale der Absolutfeldmeßgeräte nur hinreichend zu minimieren, wenn diese von annähernd gleichen Störfeldern durchsetzt werden. Bei der Verwendung von Gradiometern entspricht der Begriff "Basisbreite des Gradiometers" in seiner Bedeutung für die Empfindlichkeit dieser Geräte gegenüber Störfeldern dem oben erklärten Abstand der Absolutfeldmeßgeräte.

Gemäß dem Stand der Technik (DE 298 12 531 U1) ist eine Meßvorrichtung zur Bestimmung eines einen elektrischen Leiter durchfließenden Stromes bekannt. In dieser Druckschrift ist die Aufgabe gestellt, für die Messung von Strömen mit Hilfe von Magnetfeldsensoren Anordnungen anzugeben, die bei einfachem und kostengünstigem Aufbau auch bei großen Lagetoleranzen der Sensorelemente gegenüber dem Stromleiter Meßfehler vermeiden. Weiterhin ist auch die Messung mehrerer Ströme, die in unmittelbarer Nachbarschaft fließen, mit geringem Meßfehler vorgesehen. Hierbei tritt jedoch der Nachteil auf, daß diese Messung mehrerer Ströme mit den angegebenen Anordnungen in nur äußerst eingeschränktem Maße erreichbar ist, weil die magnetische Feldstärke der Stromleiter in Abständen, die größer als die Abmessungen des Leiterquerschnittes sind, reziprok mit zunehmendem Abstand abfällt. Sind die in der Nähe vorhandenen Störströme auch noch vom Betrag her wesentlich größer als die zu bestimmenden Ströme oder Stromänderungen, können sich als erforderliche Abstände für eine Meßgenauigkeit im Prozentbereich leicht Längen im Meterbereich als nötig erweisen. Als zusätzliche Störungen treten in technischer Umgebung immer noch magnetische Gleich- oder Wechselfelder auf, wie zum Beispiel das Erdmagnetfeld oder die Magnetfelder von Stahlteilen der mechanischen Konstruktion, die auch beweglich sein können. Diese schließen eine hohe Meßgenauigkeit bei der Bestimmung von Strömen aus dem Absolutwert des von ihnen erzeugten Magnetfeldes grundsätzlich aus.

In der Patentschrift US 5,180,970 A wird ein Stromsensor beschrieben, der nicht nur einen, sondern mindestens zwei Ringe aus weichmagnetischem Material enthält. Der magnetische Sensor befindet sich in einem Raum, der durch die beiden Spalte in den Ringen gebildet wird. Die Verschiebung der Spalte gegeneinander ermöglicht eine genauere Eichung der Stromanzeige des magnetischen Sensors. Da auch hier weichmagnetische Ringe verwendet werden, werden die Nachteile der sehr voluminösen Anordnung des durch die Sättigung des magnetischen Materials begrenzten Linearitätsbereiches und des wegen der Hysterese stark begrenzten Frequenzbereiches des Stromsensors nicht aufgehoben.

In der Patentschrift US 5,451,865 A wird zur Messung sehr großer Ströme vorgeschlagen, nicht den Strom selbst der Meßanordnung zuzuführen, sondern diesen in eine Brückenschaltung einzuspeisen. Gemessen wird dann der zum Strom selbst proportionale Wert des Querstromes der Brücke, der gegenüber dem Strom stark verringert ist. Die Probleme der Strommessung selbst werden hier also nicht gelöst, sondern günstigsten Falles in ihrem Ausmaß verringert. Sehr nachteilig ist die durch die Einschaltung der Meßbrücke in den Stromkreis bedingte hochohmige Last, die die Anwendung für hohe Ströme ausschließt.

In der Patentschrift EP 0 061 520 A1 werden einerseits Anordnungen von magnetischen Sensoren in der Nähe von Leitern vorgeschlagen, die den Strom im Wesentlichen in einer Richtung leiten. Um hier genaue Stromwerte zu erhalten, ist eine Positioniergenauigkeit für den Ort des Sensors gegenüber den Leitern erforderlich, deren einfache Einstellung den Stand der Technik überfordert.
Die andererseits angegebene Anordnung für eine spezielle Form des Stromleiters als doppeltes "U" setzt die Ansprüche an die Justage des Sensors zwar herab, jedoch ist die Geometrie des Doppel-U in wirtschaftlicher Weise kaum mit der genügenden Genauigkeit reproduzierbar, wenn man berücksichtigt, dass die Abmessungen der magnetischen Sensoren aus Kostengründen bei der Größe von etwa einem Millimeter liegen müssen.

Die Tatsache, daß der Abstand zwischen den Absolutfeldmeßgeräten bei der DE 44 34 417 A1 vom Primärleiterquerschnitt abhängt, ist insbesondere im Hochstrombereich, der sowohl durch große Primärleiterquerschnitte als auch durch hohe Störfelder gekennzeichnet ist, von Nachteil.

Der im Patentanspruch 1 angegebenen Erfindung liegt das Problem zugrunde, die Nachteile der beiden beschriebenen Meßverfahren, das heißt die Verwendung eines U-förmigen Primärleiters bei dem gradiometrischen Meßverfahren und der vorgegebenen Basisbreite bei dem Meßverfahren mit mindestens zwei Absolutfeldmeßgeräten, zu beseitigen. Zu diesem Zweck wird eine Vorrichtung und ein Verfahren angegeben, das es erlaubt, an einem geraden Primärstromleiter entweder mit Hilfe eines Gradiometers oder mindestens zweier Absolutfeldmeßgeräte potentialfrei und unter weitgehender Ausschaltung externer Störfelder Strom zu messen.

Diese Aufgabe wird erfindungsgemäß dadurch gelöst,
a) daß die Bildung des oder der Magnetfeldgradienten jeweils durch einen Leiter erfolgt, der mit einer oder mehreren geeigneten Aussparungen, beispielsweise Nuten oder Schlitzen, versehen und am Orte der Messung vorzugsweise gerade ausgeprägt ist,
   oder
b) durch die entsprechende geeignete Anordnung der leitfähigen Bauteile, die einen am Orte der Messung vorzugsweise geraden Stromleiter mit einer oder mehreren entsprechenden Aussparungen bilden,
erfolgt, und daß die Messung des Magnetfeldes oder des Magnetfeldgradienten jeweils durch geeignete Vorrichtungen in der Umgebung einzelner Aussparungen vorgenommen wird.

Die Erfindung ermöglicht die Messung des Magnetfeldgradienten beispielsweise in einer Nut in einem massiven Stromleiter. Diese Maßnahme führt zu einem kompakteren Aufbau und geringeren Herstellkosten, da gegenüber sonstigen Gradiometeranordnungen die Notwendigkeit der U-förmigen Ausführung des Primärleiters entfällt. Gegenüber den oben beschriebenen Anordnungen mit mindestens zwei Absolutfeldmeßgeräten, die außerhalb eines geraden Leiters angeordnet sind, ist die Möglichkeit der Realisierung variabler, insbesondere vom Primärleiterquerschnitt unabhängiger Basisbreiten hervorzuheben. Hierbei ist es möglich, die gewünschte Basisbreite durch die Bauart des verwendeten Gradiometers vorzugeben oder zwei oder mehrere Absolutfeldmeßgeräte in dem gewünschten Abstand voneinander anzubringen und mit ihrer Hilfe den Magnetfeldgradienten zu messen.

Des weiteren kann davon ausgegangen werden, daß die Messung eines innerhalb oder in unmittelbarer Nähe der Aussparung befindlichen Magnetfeldgradienten ohnehin mit geringeren Störfeldern behaftet ist als die Messung von Gradienten oder Absolutfeldern weit außerhalb desselben. Dieser Effekt scheint zunächst mit der klassischen Elektrodynamik schwer zu erklären, da die leitfähigen Materialien, die den erfindungsgemäßen Stromleiter bilden, zunächst nur Abschirmung gegen elektrische Felder gewährleisten dürften.

Das angesprochene Phänomen ist allerdings reproduzierbar meßbar und kann auf Wirbelströme im Primärleiter zurückgeführt werden, die insbesondere auf die verursachenden wechselnden äußeren Felder dämpfend wirken.

Zu den angesprochenen Vorteilen, die vorwiegend physikalischer Art sind, kommt ein weiterer fertigungstechnischer Aspekt hinzu:

Bei einer Vorrichtung gemäß der DE 43 00 605 C2 ist die Genauigkeit, mit der der U-förmige Primärleiter zum eigentlichen magnetoresistiven Sensorelement positioniert wird, von großer Bedeutung für die Meßgenauigkeit und den Meßbereich des Gradiometers. In Analogie zu dieser Problemstellung ist der Abstand und die Symmetrie der Absolutfeldmeßgeräte bei einer Vorrichtung gemäß der DE 44 34 417 A1 eine kritische Größe, deren Einhaltung oft zusätzlichen Aufwand erfordert.

Ein Gradiometer oder eine Anordnung von Absolutfeldmeßgeräten, die Magnetfeldgradienten messen kann, wird vorzugsweise mit mikrosystemtechnischen Fertigungsmethoden hergestellt und oft mit der nötigen Auswerteelektronik integriert werden. In Verbindung mit modernen Verfahren der Häusung und Verkapselung derartiger Mikrosysteme können daher die mechanischen Fertigungstoleranzen in engen Grenzen gehalten werden.

Die Bereitstellung einer erfindungsgemäßen Aussparung in dem Primärleiter, die beispielsweise durch das Fräsen einer Nut vorgenommen werden kann, ist ebenfalls schon mit den Mitteln des klassischen Maschinenbaus mit einer Genauigkeit von einigen Hundertstel Millimetern möglich. Zur Verbindung beider Bauteile sind dann nur noch kostengünstige und im Maschinen- und Fahrzeugbau übliche Steckverfahren oder ähnlich kostengünstige Fertigungsverfahren vonnöten, so daß zur Gewährleistung der erforderlichen Positionierungsgenauigkeit keine zusätzlichen Maßnahmen mehr erforderlich sind.

Ein weiterer Vorteil der Erfindung liegt in der Möglichkeit, beispielsweise hohe Ströme durch mehrfach geschlitzte Leiter so zu unterteilen, daß die Gradienten zwischen den einzelnen Leiterströmen nicht zu groß für Meßgeräte werden, die für die Messung kleinerer Ströme optimiert sind. Dieser Vorteil wiegt um so schwerer, da die großen Stückzahlen und damit relativ geringen Herstellkosten in Strombereichen realisiert werden dürften, in denen eine Mehrfachunterteilung des Leiters nicht zwingend vonnöten ist. Trotz dieser Tatsache kann ein erfindungsgemäßer Stromleiter mit mehreren Aussparungen auch dann nützlich sein, wenn die Meßsignale, die in der Umgebung verschiedener erfindungsgemäßer Aussparungen aufgenommen werden, mathematisch geschickt miteinander verknüpft werden. Auf diese Weise können Störfelder noch wirkungsvoller unterdrückt werden als durch die Aufzeichnung eines Gradienten.

Wie schon mehrfach erwähnt, sind vorteilhafte Ausführungsformen der Erfindung sowohl mit monolithisch oder auf andere Art integrierten Gradiometern als auch mit geeigneten Anordnungen von Absolutfeldmeßgeräten möglich.

Bei dem Einsatz von Gradiometern ist die Empfindlichkeitsrichtung der magnetfeldempfindlichen Bereiche derselben zu beachten. Insbesondere bei einer Vorrichtung gemäß der DE 43 00 605 C2 ist es vorteilhaft, den in der zitierten Veröffentlichung beschriebenen Sensorchip so auszurichten, daß das Basissubstrat desselben gegenüber der Fläche, die von der Stromflußrichtung und den Mittelpunkten der Querschnittsflächen der beiden Leiterteile, die eine erfindungsgemäße Aussparung umgeben, aufgespannt wird, um etwa 45° geneigt ist. Auf diese Weise wird gewährleistet, daß die Feldlinien die magnetoresistiven Bereiche in besonders vorteilhafter Form durchdringen.

Bei anderen Magnetfeldgradiometern, die auf der Basis des GMR, des CMR, des Hall-Effektes oder anderer magnetfeldempfindlicher Effekte funktionieren können, erscheint allein schon aus fertigungstechnischen Gründen die zu dieser Fläche annähernd orthogonale Ausrichtung des Gradiometers als vorteilhaft. Natürlich erscheint es auch möglich, auf der Basis des AMR einen Sensor zu bauen, dessen magnetoresistive Bereiche so ausgeformt sind, daß eine gerade Ausrichtung des Sensors auch physikalisch vorteilhaft wird. Insbesondere bei auf der Basis des Hall-Effektes arbeitenden Gradiometern, deren magnetfeldempfindliche Bereiche planar auf einem Basissubstrat aufgebracht sind, erscheint eine Ausrichtung des Basissubstrats parallel zu der vorgenannten Fläche als vorteilhaft. Unabhängig von diesen Überlegungen erscheint es möglich, mit einem Großteil der vorgenannten Effekte Gradiometer zu bauen, die sich in der einen oder anderen Weise physikalisch vorteilhaft und fertigungstechnisch günstig in der erfindungsgemäßen Aussparung oder in ihrer Umgebung anordnen lassen.

Bei der Verwendung von Anordnungen von Absolutfeldmeßgeräten und/oder Gradiometern sind verschiedene Anordnungen denkbar.

Vorteilhafte Anordnungen dieser Meßgeräte sollen zunächst lediglich am Beispiel eines Leiters mit einer erfindungsgemäßen Aussparung näher erläutert werden, um den Umfang des folgenden Textes in Grenzen zu halten:

Um die Vorteile dieser Anordnungen auszunutzen, erscheint es zunächst vorteilhaft, eine gerade Anzahl von Magnetfeld- oder Magnetfeldgradientenmeßgeräten gleicher Bauart symmetrisch in einer erfindungsgemäßen Nut oder deren Umgebung anzuordnen, wobei die Ausgangssignale der jeweiligen Meßgeräte in der Umgebung einer Aussparung durch geeignete mathematische Operationen, wie beispielsweise die Subtraktion, insbesondere so miteinander verknüpft werden, daß die Störanteile minimiert werden.

Des weiteren kann es auch vorteilhaft sein, eine solche Meßanordnung durch geeignete Maßnahmen, wie die bewußte asymmetrische Anbringung derselben, zu dejustieren, um den Meßbereich der Anordnung zu verschieben oder auszuweiten. Maßnahmen dieser Art erscheinen besonders sinnvoll, da der Magnetfeldgradient, der in der erfindungsgemäßen Aussparung erzeugt wird, in der Regel von relativ geringem Betrag ist:

Ein U-förmiger Stromleiter dreht bekanntlich die Stromflußrichtung um 180°. So ist der Magnetfeldgradient in einer Ebene oberhalb des Stromleiters parallel zur Basisbreite des Sensors (vergleiche DE 43 00 605 C2 oder Figur 3) oft größer als der Magnetfeldgradient einer erfindungsgemäßen Anordnung bei gleichem Primärstrom.

Maßnahmen wie die bewußte Dejustage der Magnetfeld- oder Magnetfeldgradientenmeßgeräte gegenüber dem Nulldurchgang des magnetischen Feldes können durch elektronische Maßnahmen oder Kalibrierung in geeigneter Weise flankiert oder ausgeglichen werden.

Zu den Maßnahmen, die ebenfalls zur Optimierung des magnetischen Flusses in der Umgebung einer erfindungsgemäßen Aussparung beitragen können, gehört die Anordnung von Bauteilen aus Materialien, die den magnetischen Fluß in geeigneter Form führen können. So kommt es zu einer erheblichen Steigerung des magnetischen Flusses in der erfindungsgemäßen Aussparung, wenn der Leiter teilweise mit Ferritmaterial umhüllt wird. Auch diese Maßnahme kann sowohl mit dem Ziel durchgeführt werden, den Magnetfeldgradienten symmetrisch zum Nulldurchgang des magnetischen Feldes auf die Bedürfnisse der Anwendung und der Meßvorrichtung zu optimieren, als auch mit der Absicht, ein zum Nulldurchgang asymmetrisches Feld zu erzeugen.

Zur Realisierung der letztgenannten Absicht ist es ebenfalls möglich, den gesamten erfindungsgemäßen Stromleiter in Stromflußrichtung asymmetrisch zu der Aussparung auszulegen. Auf diese weise werden auf beiden Seiten der Aussparung unterschiedliche Ströme oder Stromflußdichten zustandekommen, was den gewünschten obengenannten Effekt zur Folge hat.

Es ist vor dem Hintergrund des Standes der Mikrosystemtechnik - wie beispielsweise der Flipchiptechnologie - unter anderem vorteilhaft, die Gradiometer oder Magnetfeldmeßgeräte zunächst auf einem oder mehreren Trägern, wie zum Beispiel Folien, zu befestigen und das entstandene Mikrosystem in oder in der Nähe der Aussparung zu positionieren. Auf diese Weise wird ein besonders kostengünstiger und einfacher Aufbau realisiert.

Eine weitere vorteilhafte Ausführungsform der Erfindung liegt in der Möglichkeit begründet, ein oder mehrere Magnetfeld- oder Magnetfeldgradientenmeßsysteme so zu fertigen, daß es oder sie in der erfindungsgemäßen Aussparung relativ genau positioniert oder befestigt werden können. Auf diese Weise entfällt die relativ aufwendige Positionierung des Meßsystems zum Leiter, die normalerweise notwendig ist, um eine genaue Messung mit hinreichendem Meßbereich zu gewährleisten.

Erfindungsgemäße Vorrichtungen stellen die insbesondere für die potentialfreie Strommessung nützlichen Magnetfeldgradienten zur Verfügung, so daß es in verschiedenen Strom- oder Temperaturbereichen oder unter dem Einfluß sonstiger unterschiedlicher Umweltbedingungen vorteilhaft erscheint, mit unterschiedlichen Magnetfeld- oder Magnetfeldgradientenmeßgeräten, die auf der Basis einer Vielzahl verschiedener Prinzipien oder Effekte arbeiten, gemäß dem erfindungsgemäßen Verfahren zu messen.

Die gewonnenen Meßwerte werden natürlich oft auch zur Ableitung oder Ermittlung verwandter Größen wie Spannung oder Leistung dienen.

Insbesondere im Hochstrombereich kann aufgrund des Vorkommens großer Störfelder eine magnetische Abschirmung der gesamten Vorrichtung oder eines Teils derselben notwendig werden, wie zum Beispiel die Anbringung zusätzlicher Metallteile, zum Beispiel in der Ausführung als Blech, aufgedampfte Metallschicht oder metallpartikelhaltiger Kunststoffe und/oder weichmagnetischer Materialien, die insbesondere auch integraler Bestandteil der Magnetfeldmeßgeräte selbst, zum Beispiel der verwendeten Sensorchips und/oder des Sensor-Mikrosystems und/oder des Gehäuses der Sensoranordnung sein können, gegen äußere elektromagnetische Störfelder abgeschirmt wird.

Aufgrund der außerordentlichen Kompaktheit derselben ist auch eine solche Abschirmvorrichtung mit geringem Aufwand zu realisieren.

Bei Kurz- oder Erdschlüssen fließen schon bei Geräten mit niedrigen Nennströmen zeitweise sehr hohe Ströme, die mit dem erfindungsgemäßen Verfahren leicht detektiert werden können. Die Ausgangssignale der Meßgeräte können dann beispielsweise zur Überwachung verwendet werden.

Aufgrund der Kompaktheit der Vorrichtung und der damit verbundenen Möglichkeit der einfachen magnetischen Abschirmung eignet sich das Verfahren natürlich besonders gut dazu, auf relativ engem Raum mehrere Ströme mit Hilfe mehrerer erfindungsgemäßer Stromleiter zu detektieren.

Eine weitere kostengünstige Möglichkeit der Strommessung ergibt sich ebenfalls aus der Abschirmung oder Abschirmbarkeit der Erfindung: Sind bei einer Anwendung nur minimale Störfelder am Orte der Magnetfeld- beziehungsweise Magnetfeldgradientenmessung zu erwarten, so genügt es, nur auf einer Seite des Nulldurchgangs des magnetischen Feldes zu messen. Eine solche Messung kann schon mit einem Absolutfeldmeßgerät durchgeführt werden.

Die vorzugsweise industrielle Vorfertigung der gesamten Einheit als Vorrichtung zur potentialfreien Strommessung verspricht eine erhebliche Senkung der Stückkosten. Einheiten dieser Art können insbesondere an ihren Leiterenden in geeigneter Weise mit den Stromleitern, die den zu messenden Strom führen, verbunden werden. Besonders günstig sind in diesem Zusammenhang Steckverbindungen, mit denen beispielsweise Breitbandkabel an die Einheiten angeschlossen werden können.

Eine andere vorteilhafte Art, erfindungsgemäße Vorrichtungen zu fertigen, dürfte beispielsweise im Automobilbau von Interesse sein:

Hier könnte der erfindungsgemäße gradientenbildende Leiter bereits als Teil eines Zielgerätes gefertigt werden.

Ein solches Zielgerät kann zum Beispiel ein leistungsstarker Generator, eine herkömmliche Lichtmaschine, eine Brennstoffzelle oder ein Sicherungskasten sein. Bauteile dieser Art werden in außerordentlich hohen Stückzahlen und damit zu relativ niedrigen Kosten gefertigt. Auch die Realisierung von erfindungsgemäßen Aussparungen in den Stromleitern dieser Zielgeräte dürfte daher auf kostengünstige Weise möglich sein. Die zur Messung der gebildeten Magnetfeldgradienten geeigneten Vorrichtungen könnten dann als vorgefertigtes und auf die Anwendung abgestimmtes Mikrosystem angeliefert und in der Umgebung der erfindungsgemäßen Aussparungen positioniert werden.

Fertigungstechnische Maßnahmen der vorgenannten Art sind natürlich in verschiedenen Ausprägungen vorteilhaft und dürften in unterschiedlichen Branchen Verwendung finden.

Wie oben bereits erwähnt, bringt die Verwendung eines erfindungsgemäßen Leiters mit mehreren Aussparungen verschiedene Vorteile mit sich. Zunächst ist es möglich, den Primärstrom durch die mehrfache Schlitzung des Leiters so zu führen, daß die verwendeten Meßgeräte in ihrem Nennstrombereich beziehungsweise Nennfeldstärkebereich arbeiten.

Ein weiterer Vorteil liegt in der Möglichkeit der Auswertung der verschiedenen Gradienten: Die in der Umgebung verschiedener Aussparungen gewonnenen Meßwerte können in einer Weise mathematisch miteinander verknüpft werden, die zu einer weiteren Minimierung oder Eliminierung der Störanteile geeignet ist.

Zum Zwecke einer möglichst effektiven Auswertung dieser Signale kann es auch vorteilhaft sein, die Messung der verschiedenen Magnetfeldgradienten mit unterschiedlichen Verfahren durchzuführen.

Im folgenden wird die der Erfindung zugrunde liegende Problemstellung, die Erfindung und einige bevorzugte Ausführungsformen derselben anhand von Zeichnungen erläutert:

Es zeigen:
- Fig. 1: das Aubauprinzip eines herkömmlichen Hall-Wandlers mit Flußkonzentration;
- Fig. 2: die Gradientenbildung, wie sie in der DE 43 00 605 C2 gezeigt wird, anhand einer Skizze;
- Fig. 3: die potentialfreie Strommessung mit zwei Absolutfeldmeßgeräten wie sie von der DE 44 34 417 A1 vorgeschlagen wird;
- Fig. 4: eine Skizze eines Beispiels eines geschlitzten, erfindungsgemäßen Stromleiters und des Feldlinienverlaufs in seiner Umgebung;
- Fig. 5: ein Beispiel eines erfindungsgemäßen Stromleiters, der aus zwei leitfähigen Teilen zusammengesetzt ist;
- Fig. 6: einen Querschnitt durch einen erfindungsgemäßen Leiter mit einer Nut;
- Fig. 7: einen Querschnitt durch einen erfindungsgemäßen geschlitzten Leiter mit einem Gradiometer;
- Fig. 8: einen Querschnitt durch einen erfindungsgemäßen geschlitzten Leiter mit einem geneigten Gradiometer;
- Fig. 9: einen Querschnitt durch einen erfindungsgemäßen geschlitzten Leiter mit einer Anordnung von zwei Absolutfeldmeßgeräten;
- Fig. 10: einen Querschnitt durch einen erfindungsgemäßen geschlitzten Leiter mit einem Schlitz, der zur Führung des magnetischen Flusses in beispielhafter Form geführt ist und in dessen Schlitz ein Mikrosystem eingepaßt ist;
- Fig. 11: einen Querschnitt durch einen erfindungsgemäßen geschlitzten Leiter, an dem zusätzliche Bauteile zur magnetischen Flußführung abgebracht sind;
- Fig. 12: einen Querschnitt durch einen erfindungsgemäßen Leiter mit zwei Schlitzen, die eine unterschiedliche Breite aufweisen, wobei am Primärleiter ein zusätzliches Bauteil zur magnetischen Flußführung angebracht ist.

Figur 1 zeigt das Aufbauprinzip eines handelsüblichen Hall-Wandlers, bei dem ein Ferrit- oder Eisenkern (5) den magnetischen Fluß (18) eines Stromleiters (3) führt, was zu konzentriertem magnetischen Fluß (6) in der Umgebung des Hall-Wandlers führt. Bei diesem Aufbauprinzip werden insbesondere bei hohen Strömen voluminöse Eisen- oder Ferritkerne verwendet.

Figur 2 zeigt eine Magnetfeldgradientenbildung, wie sie in der DE 43 00 605 C2 und der US 5,548,208 vorgeschlagen wird, die bei Verwendung eines empfindlichen Meßsystems (1) ohne eine aufwendige magnetische Flußführung auskommt. Der in diesem Fall U-förmig ausgeprägte Primärstromleiter (3) erzeugt einen Magnetfeldgradienten, der das Gradiometer durchsetzt. Auf diese Weise ist es möglich, bei der Auswertung die Anteile der Störfelder zu minimieren.

Figur 3 zeigt eine Vorrichtung, die unter anderem von der DE 44 34 417 A1 vorgeschlagen wird. Ein gerader Stromleiter (3) besitzt ein Magnetfeld mit annähernd kreisförmigen Feldlinien (7), dessen Verformungen durch den Querschnitt des Leiters zustandekommen können. Dieses Magnetfeld durchsetzt zwei Absolutfeldmeßgeräte (1), die von dem Magnetfeld in entgegengesetzter Richtung durchdrungen werden. Die Auswertung der Ausgangssignale der beiden Meßgeräte erfolgt beispielsweise mit Hilfe eines Subtrahierers. Auf diese Weise fallen die Störanteile homogener externer Störfelder weitgehend weg. Die Höhe der verbleibenden Störanteile hängt jedoch von dem Abstand der Meßgeräte zueinander ab, der wiederum mit dem Durchmesser des Leiters zusammenhängt.

Figur 4 zeigt einen erfindungsgemäßen geschlitzten Primärleiter (3) und den von dem Primärstrom hervorgerufenen Feldlinienverlauf (7) in der Umgebung des erfindungsgemäßen Schlitzes (8).

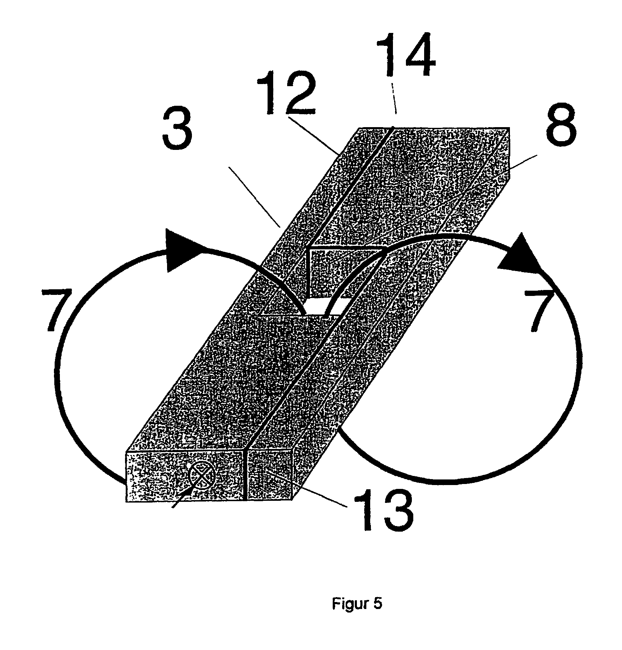

Figur 5 zeigt dieselbe Skizze, wobei der Primärleiter (3) sich aus den leitfähigen Bauteilen (12 und 13) zusammensetzt, die an der Stoßlinie (14) miteinander insbesondere leitfähig verbunden sind. Diese Skizze illustriert lediglich, daß der erfindungsgemäße Primärleiter aus einer Mehrzahl geeigneter Bauelemente zusammengesetzt sein kann.

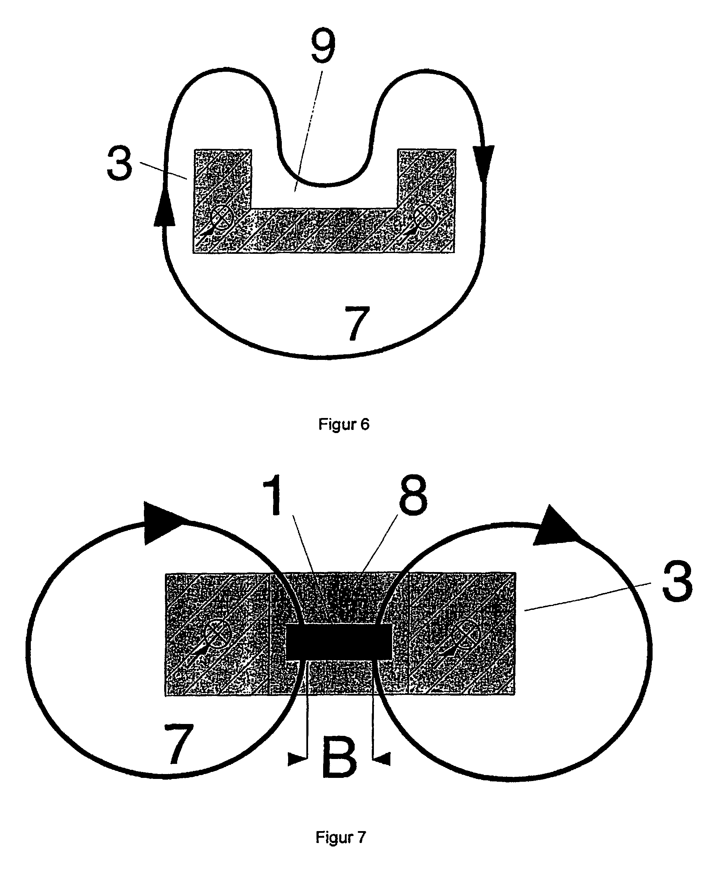

Figur 6 zeigt einen Querschnitt durch einen erfindungsgemäßen Primärleiter (3), der statt einem durchgehenden Schlitz eine Nut (9) als erfindungsgemäße Aussparung aufweist. Der Verlauf der Feldlinien ist in dieser Figur lediglich skizziert. Aus Gründen der Übersichtlichkeit beschränken sich die folgenden Figuren auf die Darstellung von Ausführungsbeispielen, die mit einem durchgängigen erfindungsgemäßen Schlitz versehen sind.

Figur 7 zeigt einen Querschnitt durch einen solchen erfindungsgemäßen Stromleiter (3). In der erfindungsgemäßen Aussparung befindet sich ein Magnetfeldmeßgerät (1), das in diesem Ausführungsbeispiel als Magnetfeldgradientenmeßgerät ausgelegt ist. Die Anordnung dieses Gradiometers ist symmetrisch zum Nulldurchgang des magnetischen Feldes. Das Basissubstrat des Gradiometers ist etwa parallel zu der Fläche, die von der Stromflußrichtung und den Mittelpunkten der beiden Leiterteile aufgespannt wird. Das Maß (B) bezeichnet die Basisbreite des Gradiometers, die insbesondere durch den Abstand verschiedener magnetfeldempfindlicher Schichten, die den Magnetfeldgradienten hier zu beiden Seiten des Nulldurchganges messen, gegeben ist.

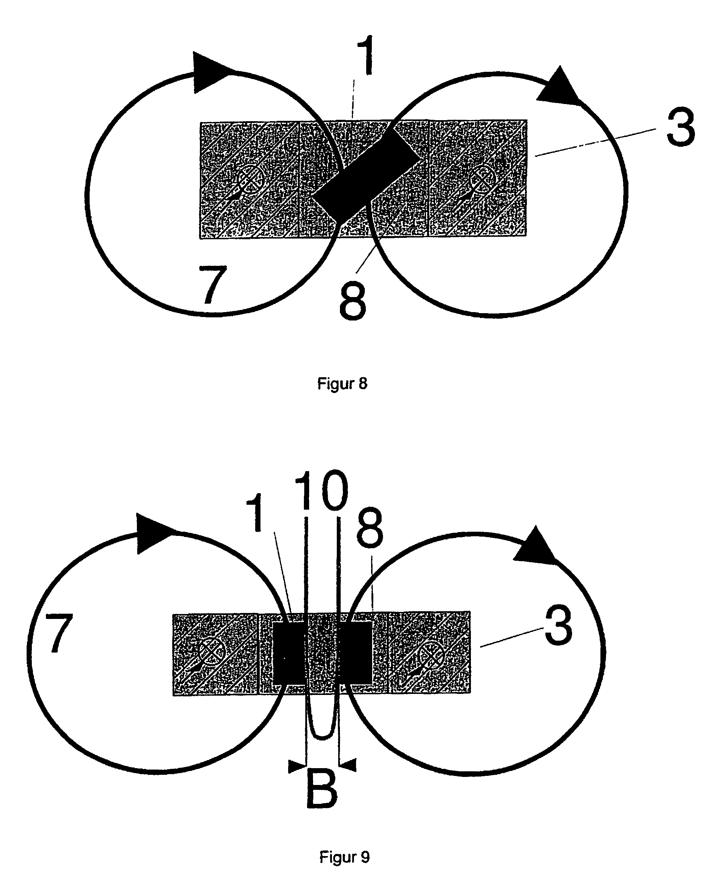

Figur 8 zeigt eine im wesentlichen identische Querschnittszeichnung, bei der das Gradiometer (1) um etwa 45° gegenüber dieser Fläche geneigt ist.

Bei Figur 9 sind zwei Absolutfeldmeßgeräte (1) in der erfindungsgemäßen Aussparung angebracht. Sie sind an einem geeigneten Träger (10) befestigt. Der Abstand der beiden Meßgeräte (1) beziehungsweise ihrer magnetfeldempfindlichen Schichten ist hier ebenfalls mit (B) bezeichnet. Er entspricht in physikalischem Sinn der Basisbreite des Gradiometers in Figur 7.

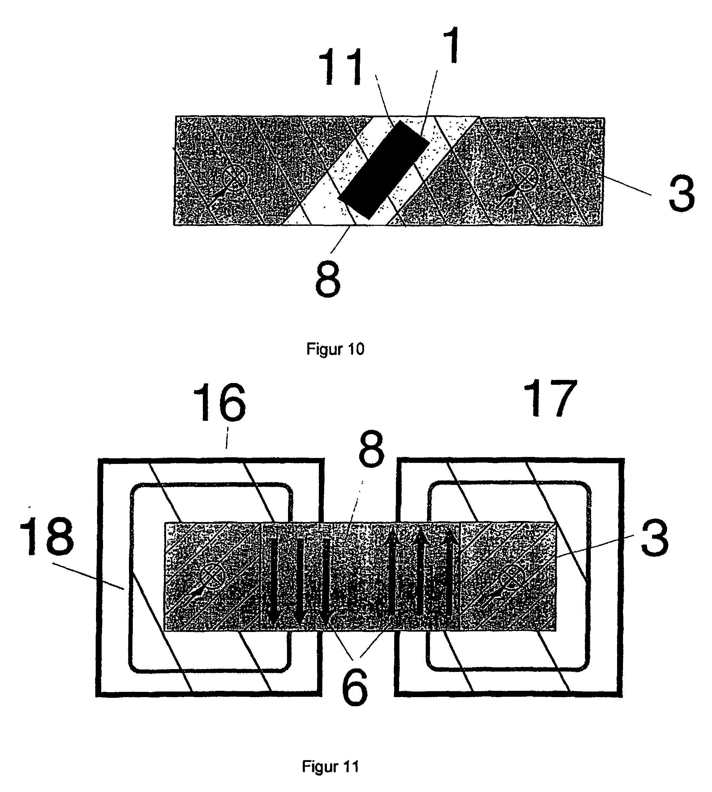

Figur 10 zeigt einen Querschnitt durch einen erfindungsgemäßen Stromleiter (3), der eine Aussparung (8) aufweist, deren Ausrichtung weniger von fertigungstechnischen als von physikalischen Überlegungen geprägt wurde. Dieser speziellen Ausrichtung kommt jedoch auch nur beispielhafte Bedeutung zu. Darüber hinaus zeigt Figur 10 ein Magnetfeld- oder Magnetfeldgradientenmeßgerät (1), das in einen Teil eines Mikrosystems (11) eingefügt ist, das in die Aussparung (8) paßt und dort mit hinreichender Genauigkeit und geringem Aufwand zu positionieren ist.

Figur 11 zeigt einen Querschnitt durch einen erfindungsgemäßen Stromleiter (3), der von Bauteilen (16, 17) aus einem Material umgeben ist, das geeignet ist, den magnetischen Fluß zu führen. Ein solches Material ist beispielsweise Ferrit. Durch diese Maßnahme wird der Fluß innerhalb des Materials in weniger konzentrierter Form (18) geführt und eine Konzentration oder Hinführung des magnetischen Flusses beispielsweise am Orte der Messung desselben erreicht. Wird eines der beiden Bauteile (16, 17) weggelassen oder werden die beiden Bauteile mit unterschiedlicher Größe oder unterschiedlichem Material ausgefertigt, so entsteht ein zu der erfindungsgemäßen Aussparung asymmetrisches Gradientenfeld.

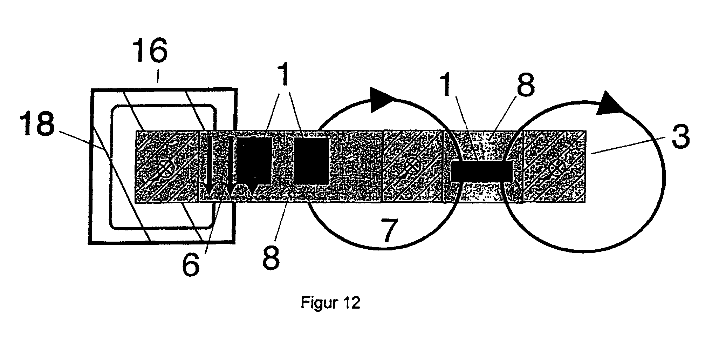

Figur 12 zeigt einen Querschnitt durch einen erfindungsgemäßen Leiter (3), der mit zwei Aussparungen versehen ist und zwei Gradienten bildet. Dieser Leiter bildet jedoch ein asymmetisches Gradientenfeld, da der linke Schlitz (8) breiter ist als der rechte und das linke Leiterteil über ein Bauteil (16) zur magnetischen Flußführung verfügt. Durch diese Maßnahme wird der magnetische Fluß (6) konzentriert, so daß das linke Magnetfeldgradientenmeßgerät (1), das anders beschaffen ist als das rechte Meßgerät, einem asymmetrischen Magnetfeld ausgesetzt ist. Diese letzte Figur dient vor allem der beispielhaften Veranschaulichung der Vielfalt der Ausführungsformen der Erfindung.

Weitere Vorrichtungen mit mehreren erfindungsgemäßen Aussparungen sind an dieser Stelle nicht dargestellt, um die Zahl der Figuren nicht noch weiter zu erhöhen.

Auch andere Maßnahmen zur Herstellung eines asymmetrischen Gradientenfeldes oder zur asymmetrischen Positionierung des Magnetfeld- oder Magnetfeldgradientenmeßsystems sind aus Gründen der Übersichtlichkeit nicht anhand von Zeichnungen dargestellt. Auch auf die Darstellung runder, ellipsoider, dreieckiger, vieleckiger oder in sonstiger Weise geformter Leiterquerschnitte wurde lediglich aus Gründen der Übersichtlichkeit verzichtet.

### Bezugszeichenliste

- 1: Magnetfeld- oder Magnetfeldgradientenmeßgerät beziehungsweise Absolutfeldmeßgerät oder Gradiometer
- 2: Hall-Wandler
- 3: Primärleiter
- 4: potentialtrennendes Substrat
- 5: Ferrit- oder Eisenkern
- 6: konzentrierter magnetischer Fluß
- 7: Feldlinien des primären Magnetfeldes
- 8: Schlitz oder Aussparung
- 9: Nut oder Aussparung
- 10: Trägermaterial, beispielsweise Folie
- 11: Teil des Mikrosystems, beispielsweise aus geeigneter Vergußmasse bestehend
- 12: leitfähiges Bauteil
- 13: leitfähiges Bauteil
- 14: Stoßlinie zwischen den leitfähigen Bauteilen
- 15: Anschlüsse der Absolutfeldmeßgeräte und Auswerteelektronik, beispielsweise Subtrahierer
- 16: Bauteil aus einem Material, das den magnetischen Fluß führt, beispielsweise Ferrit
- 17: Bauteil aus einem Material, das den magnetischen Fluß führt, beispielsweise Ferrit
- 18: "geführter" weniger konzentrierter magnetischer Fluß
- B: Basisbreite eines Gradiometers, Abstand zwischen zwei Absolutfeldmeßgeräten oder ähnliches

## Patentansprüche

1. Vorrichtung zum potentialfreien Messen eines Stromes durch Bestimmung eines von dem Strom verursachten Magnetfeldes (7) oder dessen Gradienten, **dadurch gekennzeichnet, daß** ein von dem Strom durchflossener Leiter (3) mindestens eine Aussparung (8, 9) aufweist, und daß die Aussparung (8, 9) in dem Leiter (3) so angeordnet ist, daß die Richtung des Stromes in zu der Aussparung (8, 9) angrenzenden Bereichen des Leiters (3) wenigstens annähernd übereinstimmt, und daß wenigstens ein Meßelement (1) zur Bestimmung des Magnetfeldes (7) oder dessen Gradienten in der wenigstens einen Aussparung (8, 9) vorgesehen ist.

2. Vorrichtung nach Anspruch 1, **dadurch gekennzeichnet, daß** der Leiter (3) aus mehreren Bauteilen (12, 13) besteht, wobei durch die Anordnung der Bauteile (12, 13) wenigstens eine Aussparung (8, 9) gebildet wird.

3. Vorrichtung nach Anspruch 1 oder 2, **dadurch gekennzeichnet, daß** der Leiter (3) am Orte der Messung in Stromflußrichtung gerade ausgebildet ist.

4. Vorrichtung nach Anspruch 1 oder 2, **dadurch gekennzeichnet, daß** die wenigstens eine Aussparung (8, 9) als Nut oder Schlitz ausgebildet ist.

5. Vorrichtung nach Anspruch 1, **dadurch gekennzeichnet, daß** das wenigstens eine Meßelement (1) als magnetisches Gradiometer oder Differenzfeldmeßgerät ausgebildet ist.

6. Vorrichtung nach Anspruch 1, **dadurch gekennzeichnet, daß** das wenigstens eine Meßelement (1) als Absolutfeldmeßgerät ausgebildet ist.

7. Vorrichtung nach einem der Ansprüche 1 bis 5, **dadurch gekennzeichnet, daß** für die Messung einzelner oder mehrerer Gradienten jeweils ein Gradiometer (1) verwendet wird, dessen Basissubstrat gegenüber der Fläche, die von der Stromflußrichtung und den Mittelpunkten der beiden Leiterteile (12, 13), die die jeweilige Aussparung bilden, aufgespannt wird in einem Winkel zwischen 0° und 90°, wobei die Aussparungen (8, 9) des geraden Leiters derart geformt sind, daß der magnetische Fluß in einer für die jeweiligen Gradiometer (1) angepaßten Weise geführt ist und die jeweiligen Gradiometer (1) von der Aussparung (8, 9) aufgenommen werden.

8. Vorrichtung nach Anspruch 7, **dadurch gekennzeichnet, daß** das Gradiometer (1) um etwa 45° geneigt oder annähernd orthogonal oder annähernd parallel mit seinem Basissubstrat gegenüber der Fläche, die von der Stromflußrichtung und den Mittelpunkten der beiden Leiterteile (12, 13) aufgespannt wird, ausgerichtet ist.

9. Vorrichtung nach Anspruch 1, **dadurch gekennzeichnet, daß** für die Messung einzelner oder mehrerer Gradienten jeweils eine Anordnung von Absolutfeldmeßgeräten (1) verwendet wird, die aus gleichartigen oder ähnlichen Absolutfeldmeßgeräten (1) besteht, die in der jeweiligen Aussparung (8, 9) in dem Leiter (3) angebracht sind.

10. Vorrichtung nach Anspruch 9, **dadurch gekennzeichnet, daß** die Absolutfeldmeßgeräte (1) symmetrisch zum Nulldurchgang des magnetischen Feldes in der jeweiligen Aussparung (8, 9) in dem Leiter (3) angeordnet sind.

11. Vorrichtung nach Anspruch 1, **dadurch gekennzeichnet, daß** für die Messung einzelner oder mehrerer Gradienten jeweils eine Anordnung von Gradiometern (1) verwendet wird, die aus einem oder mehreren Gradiometern (1) besteht, dessen oder deren magnetfeldempfindliche Bereiche in der jeweiligen Aussparung (8, 9) in dem Leiter angeordnet sind.

12. Vorrichtung nach Anspruch 11, **dadurch gekennzeichnet, daß** das wenigstens eine Gradiometer (1) symmetrisch zum Nulldurchgang des magnetischen Feldes in der Aussparung (8, 9) in dem Leiter (3) angeordnet ist.

13. Vorrichtung nach Anspruch 1, **dadurch gekennzeichnet, daß** für die Messung einzelner oder mehrerer Gradienten jeweils eine Anordnung von Absolutfeldmeßgeräten (1) oder Gradiometern (1) verwendet wird, die eine oder verschiedene Asymmetrien in der Anordnung oder Kalibrierung ihrer magnetfeldempfindlichen Bereiche zum Nulldurchgang des magnetischen Feldes aufweisen, wobei die Ausgangssignale der jeweiligen Magnetfeldmeßsysteme durch mathematische Operationen derart miteinander verknüpft werden, daß die Störanteile minimiert werden.

14. Vorrichtung nach Anspruch 13, **dadurch gekennzeichnet, daß** die Anordnung von Absolutfeldmeßgeräten (1) oder Gradiometern (1) aus einer ungeradzahligen Anzahl gleichartiger oder ähnlicher Absolutfeldmeßgeräte (1) oder Gradiometer (1) im Bereich des Nulldurchgangs besteht.

15. Vorrichtung nach Anspruch 13, **dadurch gekennzeichnet, daß** die Anordnung aus verschiedenartigen oder verschiedenartig kalibrierten Absolutfeldmeßgeräten (1) oder Gradiometern (1) besteht.

16. Vorrichtung nach Anspruch 13, **dadurch gekennzeichnet, daß** die Anordnung als asymmetrische Anordnung symmetrischer Gradiometer (1) oder von Anordnungen von Absolutfeldmeßgeräten (1) zum Nulldurchgang des magnetischen Feldes ausgebildet ist.

17. Vorrichtung nach Anspruch 1, **dadurch gekennzeichnet, daß** der Leiter (3) ganz oder teilweise von einem zur Führung des magnetischen Flusses geeigneten Material (16, 17) umgeben ist.

18. Vorrichtung nach Anspruch 1, **dadurch gekennzeichnet, daß** der Leiter (3) in der Stromflußrichtung asymmetrisch zu der oder den Aussparungen (8, 9) ausgeprägt ist für eine Optimierung des Magnetfeldgradienten.

19. Vorrichtung nach Anspruch 1, **dadurch gekennzeichnet, daß** das wenigstens eine Gradiometer (1) oder die Anordnung von Absolutfeldmeßgeräten (1) an wenigstens einem Träger (10) mit mikrosystemtechnischen Mitteln befestigt und zusammen mit dem wenigstens einen Träger (10) in wenigstens einer Aussparung (8, 9) oder deren Umgebung positioniert ist.

20. Vorrichtung nach Anspruch 1, **dadurch gekennzeichnet, daß** das oder die Magnetfeld- oder Magnetfeldgradientenmeßsysteme (1) als auf der Basis des Hall-Effektes arbeitende Magnetfeld- oder Magnetfeldgradientenmeßsysteme (1) ausgebildet sind.

21. Vorrichtung nach Anspruch 20, **dadurch gekennzeichnet, daß** das oder die Magnetfeld- oder Magnetfeldgradientenmeßsysteme (1) in Form von Feldplatten oder von vertikalen oder zylindrischen integrierten Hall-Sensoren ausgebildet sind.

22. Vorrichtung nach Anspruch 20, **dadurch gekennzeichnet, daß** die Vorrichtung mikrosystemtechnisch integrierte Flußkonzentratoren aufweist.

23. Vorrichtung nach Anspruch 20, **dadurch gekennzeichnet, daß** das oder die Magnetfeld- oder Magnetfeldgradientenmeßsysteme (1) magnetempfindliche Bereiche enthalten, die unter Verwendung von IV- oder III-V-Halbleitermaterialien mit Standardverfahren der Halbleiterherstellung, wie der Bipolar-, CMOS- oder BICMOS-Technologie herstellt worden sind.

24. Vorrichtung nach Anspruch 1, **dadurch gekennzeichnet, daß** das oder die Magnetfeldgradienten- oder Magnetfeldgradientenmeßsysteme (1) auf der Basis des anisotropen, gigantischen, kolossalen oder anderen magnetoresistiven Effektes (AMR, GMR, CMR) arbeiten.

25. Vorrichtung nach Anspruch 1, **dadurch gekennzeichnet, daß** das oder die Magnetfeld- oder Magnetfeldgradientenmeßsysteme (1) als das transformatorische Prinzip verwendende Magnetfeld- oder Magnetfeldgradientenmeßsysteme (1) ausgebildet sind.

26. Vorrichtung nach Anspruch 1, **dadurch gekennzeichnet, daß** das oder die Magnetfeld- oder Magnetfeldgradientenmeßsysteme (1) als auf der Basis des Josephson-Effektes arbeitende Magnetfeld- oder Magnetfeldgradientenmeßsysteme (1) ausgebildet sind.

27. Vorrichtung nach einem der Ansprüche 20 bis 26, **dadurch gekennzeichnet, daß** das oder die Magnetfeld- oder Magnetfeldgradientenmeßsysteme (1) als auf einer Kombination der Prinzipien oder Effekte arbeitendes Magnetfeld- oder Magnetfeldgradientenmeßsystem (1) ausgebildet ist.

28. Vorrichtung nach Anspruch 1, **dadurch gekennzeichnet, daß** die Vorrichtung als eine von Strom ableitbare Größen ermittelnde Vorrichtung ausgebildet ist.

29. Vorrichtung nach Anspruch 1, **dadurch gekennzeichnet, daß** wenigstens ein Teil der Vorrichtung gegen äußere elektromagnetische Störfelder abgeschirmt ist.

30. Vorrichtung nach Anspruch 1, **dadurch gekennzeichnet, daß** die Vorrichtung als eine die Ausgangssignale der Magnetfeld- oder Magnetfeldgradientenmeßsysteme (1) zur Detektion von Überströmen nutzende Vorrichtung ausgebildet ist.

31. Vorrichtung nach Anspruch 1, **dadurch gekennzeichnet, daß** die Vorrichtung als Einheit zur potentialfreien Strommessung ausgebildet ist und Leiterenden aufweist, die mit den zu messenden Strom führenden Stromleitern verbindbar sind.

32. Vorrichtung nach Anspruch 1, **dadurch gekennzeichnet, daß** der gradientenbildende Leiter (3) als Teil eines Zielgerätes gefertigt oder in diesem enthalten ist, und daß die Vorrichtung zur Messung des Gradienten in vorgefertigter Form in der Umgebung der Aussparungen (8, 9) angeordnet ist.

33. Vorrichtung nach Anspruch 1, **dadurch gekennzeichnet, daß** die Vorrichtung als eine bei der Messung hoher Ströme die Meßwerte verschiedener Magnetfeld- oder Magnetfeldgradientenmeßsysteme (1), die in Aussparungen (8, 9) eines Leiters (3) oder in der Umgebung verschiedener Aussparungen (8, 9) eines Leiters (3) gemessen werden, bei der Auswertung mathematisch miteinander verknüpfende Vorrichtung ausgebildet ist, derart, daß die Störanteile minimiert oder eliminiert werden.

34. Verfahren zur potentialfreien Strommessung mit Hilfe einer Vorrichtung nach einem der Ansprüche 1 bis 33 durch die Aufzeichnung des von dem jeweiligen primären Strom in einem Leiter (3) verursachten Magnetfeldes oder dessen Gradienten, bei dem das Magnetfeld oder dessen Gradient gemessen wird, bei dem der Leiter (3) mit wenigstens einer Aussparung (8, 9) versehen ist, und bei dem die Messung des Magnetfeldes oder dessen Gradienten jeweils in der Umgebung einzelner Aussparungen (8, 9) durchgeführt wird.

35. Verfahren nach Anspruch 34, **dadurch gekennzeichnet, daß** die Messung des Magnetfeldgradienten oder des Magnetfeldes eines Stromleiters (3) erfolgt, der aus mehreren Bauteilen (12, 13) besteht, wobei durch die Anordnung der Bauteile (12, 13) die wenigstens eine Aussparung (8, 9) gebildet wird.

## Claims

1. A device for measuring a current in an isolated circuit by determining a magnetic field (7) generated by the current, or the gradients of said magnetic field, **characterised in that** a conductor (3) through which the current passes has at least one recess (8, 9), and **in that** the recess (8, 9) is so arranged in the conductor (3) that the direction of the current at least approximately corresponds in regions of the conductor (3) adjacent the recess (8, 9), and **in that** at least one measuring element (1) is provided to determine the magnetic field (7) or its gradients in the at least one recess (8, 9).

2. A device according to claim 1, **characterised in that** the conductor (3) consists of a plurality of components (12, 13), at least one recess (8, 9) being formed by the arrangement of the components (12, 13).

3. A device according to claim 1 or 2, **characterised in that** the conductor (3) is straight at the place of measurement in the direction of current flow.

4. A device according to claim 1 or 2, **characterised in that** the at least one recess (8, 9) is in the form of a groove or slot.

5. A device according to claim 1, **characterised in that** the at least one measuring element (1) is in the form of a magnetic gradiometer or differential field measuring device.

6. A device according to claim 1, **characterised in that** the at least one measuring element (1) is in the form of an absolute field measuring device.

7. A device according to any one of claims 1 to 5, **characterised in that** individual or a plurality of gradients are in each case measured by a gradiometer (1), whose base substrate [lacuna - is aligned] at an angle of between 0° and 90° relative to the face that is clamped by the direction of current flow and the centre points of the two conductor portions (12, 13) forming the respective recess, the recesses (8, 9) of the straight conductor being shaped in such a way that the magnetic flux is guided in a manner adapted to the respective gradiometers (1) and the respective gradiometers (1) are received by the recess (8, 9).

8. A device according to claim 7, **characterised in that** the gradiometer (1) is aligned with its base substrate inclined about an angle of 45° relative to or approximately perpendicular or approximately parallel to the face that is clamped by the direction of current flow and the centre points of the two conductor portions (12, 13).

9. A device according to claim 1, **characterised in that** individual or a plurality of gradients are in each case measured by an arrangement of absolute field measuring devices (1) consisting of absolute field measuring devices (1) that are of the same kind or similar and are fitted in the respective recess (8, 9) in the conductor (3).

10. A device according to claim 9, **characterised in that** the absolute field measuring devices (1) are arranged symmetrically to the zero crossing of the magnetic field in the respective recess (8, 9) in the conductor (3).

11. A device according to claim 1, **characterised in that** individual or a plurality of gradients are in each case measured by an arrangement of gradiometers (1) consisting of one or more gradiometers (1) whose regions that are sensitive to magnetic fields are arranged in the respective recess (8, 9) in the conductor.

12. A device according to claim 11, **characterised in that** the at least one gradiometer (1) is arranged symmetrically to the zero crossing of the magnetic field in the recess (8, 9) in the conductor (3).

13. A device according to claim 1, **characterised in that** individual or a plurality of gradients are in each case measured by an arrangement of absolute field measuring devices (1) or gradiometers (1) having one or more asymmetries in the arrangement or calibration of their regions that are sensitive to magnetic fields relative to the zero crossing of the magnetic field, the output signals of the respective magnetic field measuring systems being so mutually combined by mathematical operations that the interference components are minimised.

14. A device according to claim 13, **characterised in that** the arrangement of absolute field measuring devices (1) or gradiometers (1) consists of an odd number of absolute field measuring devices (1) or gradiometers (1) of the same kind or similar in the region of the zero crossing.

15. A device according to claim 13, **characterised in that** the arrangement consists of absolute field measuring devices (1) or gradiometers (1) that are of different kinds or are calibrated in different ways.

16. A device according to claim 13, **characterised in that** the arrangement is in the form of an asymmetrical arrangement of symmetrical gradiometers (1) or of arrangements of absolute field measuring devices (1) relative to the zero crossing of the magnetic field.

17. A device according to claim 1, **characterised in that** the conductor (3) is wholly or partly surrounded by a material (16, 17) suitable for guiding the magnetic flux.

18. A device according to claim 1, **characterised in that** the conductor (3), in the direction of current flow, is of an asymmetrical form relative to the recess or recesses (8, 9) in order to optimise the magnetic field gradient.

19. A device according to claim 1, **characterised in that** the at least one gradiometer (1) or the arrangement of absolute field measuring devices (1) is secured to at least one support (10) by means of microsystem technology and is positioned with the at least one support (10) in at least one recess (8, 9) or its surrounding area.

20. A device according to claim 1, **characterised in that** the magnetic field or magnetic field gradients measuring system or systems (1) is or are in the form of magnetic field or magnetic field gradients measuring systems (1) operating on the basis of the Hall effect.

21. A device according to claim 20, **characterised in that** the magnetic field or magnetic field gradients measuring system or systems (1) is or are in the form of magnetoresistors or vertical or cylindrical integrated Hall sensors.

22. A device according to claim 20, **characterised in that** the device has flux concentrators integrated by microsystem technology.

23. A device according to claim 20, **characterised in that** the magnetic field or magnetic field gradients measuring system or systems (1) incorporates or incorporate magnet-sensitive regions which have been produced using IV or III-V semiconductor materials with standard semiconductor production methods such as bipolar, CMOS or biCMOS technology.

24. A device according to claim 1, **characterised in that** the magnetic field gradients or magnetic field gradients measuring system or systems (1) operates or operate on the basis of the anisotropic, giant, colossal or other magnetoresistive effect (AMR, GMR, CMR).

25. A device according to claim 1, **characterised in that** the magnetic field or magnetic field gradients measuring system or systems (1) is or are in the form of magnetic field or magnetic field gradients measuring systems (1) using the transformer principle.

26. A device according to claim 1, **characterised in that** the magnetic field or magnetic field gradients measuring system or systems (1) is or are in the form of magnetic field or magnetic field gradients measuring systems (1) operating on the basis of the Josephson effect.

27. A device according to any one of claims 20 to 26, **characterised in that** the magnetic field or magnetic field gradients measuring system or systems (1) is or are in the form of a magnetic field or magnetic field gradients measuring system (1) operating on the basis of a combination of principles or effects.

28. A device according to claim 1, **characterised in that** the device is in the form of a device which determines variables that can be deduced from current.

29. A device according to claim 1, **characterised in that** at least a portion of the device is shielded from external electromagnetic interference fields.

30. A device according to claim 1, **characterised in that** the device is in the form of a device which uses the output signals of the magnetic field or magnetic field gradients measuring systems (1) to detect excess currents.

31. A device according to claim 1, **characterised in that** the device is in the form of a unit for measuring current in an isolated circuit and has conductor ends which can be connected to current conductors conducting the current to be measured.

32. A device according to claim 1, **characterised in that** the gradient-forming conductor (3) is manufactured as part of a target device or is incorporated therein, and **in that** the device for measuring the gradient is arranged in preassembled form in the area surrounding the recesses (8, 9).

33. A device according to claim 1, **characterised in that** the device is in the form of a device which, when high currents are measured, mutually combines the measured values of various magnetic field or magnetic field gradients measuring systems (1), which are measured in recesses (8, 9) of a conductor (3) or in the area surrounding various recesses (8, 9) of a conductor (3), mathematically during analysis so that the interference components are minimised or eliminated.

34. A method of measuring current in an isolated circuit using a device according to any one of claims 1 to 33 by recording the magnetic field generated by the respective primary current in a conductor (3), or the gradients of said magnetic field, in which method the magnetic field or the gradient thereof is measured, the conductor (3) is provided with at least one recess (8, 9), and measurement of the magnetic field or the gradients thereof is in each case carried out in the area surrounding individual recesses (8, 9).

35. A method according to claim 34, **characterised in that** measurement is carried out on the magnetic field gradient or magnetic field of a current conductor (3) consisting of a plurality of components (12, 13), the at least one recess (8, 9) being formed by the arrangement of the components (12, 13).

## Revendications

1. Dispositif de mesure sans potentiel d'un courant par détermination du champ magnétique (7) provoqué par le courant ou de son gradient, **caractérisé en ce qu'**un conducteur (3) traversé par le courant présente au moins un évidement (8, 9), et **en ce que** l'évidement (8, 9) dans le conducteur (3) est disposé de manière que la direction du courant dans les zones du conducteur (3) voisines de l'évidement (8, 9) corresponde au moins approximativement, et **en ce qu'**au moins un élément de mesure (1) est prévu pour la détermination du champ magnétique (7) ou de son gradient dans l'évidement (8, 9) au moins présent.

2. Dispositif selon la revendication 1, **caractérisé en ce que** le conducteur (3) se compose de plusieurs pièces (12, 13), au moins un évidement (8, 9) étant formé par la disposition des pièces (12, 13).

3. Dispositif selon la revendication 1 ou 2, **caractérisé en ce que** le conducteur (3) est formé en une droite à l'endroit de la mesure dans la direction du flux de courant.

4. Dispositif selon la revendication 1 ou 2, **caractérisé en ce que** l'évidement (8, 9) au moins présent est formé en rainure ou en fente.

5. Dispositif selon la revendication 1, **caractérisé en ce qu'**au moins un élément de mesure (1) est formé en gradiomètre magnétique ou en appareil de mesure de champ différentiel.

6. Dispositif selon la revendication 1, **caractérisé en ce que** l'élément de mesure (1) au moins présent est formé en appareil de mesure de champ absolu.

7. Dispositif selon l'une des revendications 1 à 5, **caractérisé en ce que** pour la mesure d'un ou de plusieurs gradients on utilise toujours un gradiomètre (1) dont le substrat de base est monté face à la surface que forme l'évidement considéré dans la direction du flux de courant et les points médians des deux pièces conductrices (12, 13), selon un angle compris entre 0 et 90°, les évidements (8,9) du conducteur droit étant formé de manière que le flux magnétique soit conduit d'une manière adaptée au gradiomètre (1) en question et que le gradiomètre (1) soit reçu par l'évidement (8, 9).

8. Dispositif selon la revendication 7, **caractérisé en ce que** le gradiomètre (1) est penché à environ 45° ou presque octogonal ou presque parallèle à son substrat de base vis-à-vis de la surface qui s'étend à partir de la direction d'écoulement du courant et des points médians des deux pièces conductrices (12, 13).

9. Dispositif selon la revendication 1, **caractérisé en ce que** pour la mesure d'un ou plusieurs gradients on utilise toujours un dispositif d'appareils de mesure de champ absolu (1) qui se compose d'appareils de mesure de champ absolu (1) identiques ou analogues, qui sont montés dans l'évidement correspondant (8, 9) dans le conducteur (3).

10. Dispositif selon la revendication 9, **caractérisé en ce que** les appareils de mesure de champ absolu (1) sont disposés symétriquement par rapport au passage à zéro du champ magnétique dans l'évidement (8, 9) dans le conducteur (3).

11. Dispositif selon la revendication 1, **caractérisé en ce qu'**on utilise toujours pour la mesure d'un ou plusieurs gradients une disposition de gradiomètres(1) qui se compose d'un ou plusieurs gradiomètres (1) dont la ou les zones sensibles au champ magnétique est ou sont disposée(s) dans l'évidemment correspondant (8, 9) dans le conducteur.

12. Dispositif selon la revendication 11, **caractérisé en ce qu'**au moins un gradiomètre (1) est disposé symétriquement par rapport au passage à zéro du champ magnétique dans l'évidemment (8, 9) dans le conducteur (3).

13. Dispositif selon la revendication 1, **caractérisé en ce que** pour la mesure d'un ou plusieurs gradients on utilise toujours une disposition des appareils de mesure de champ absolu (1) ou des gradiomètres (1) qui présentent une asymétrie ou des asymétriques différentes dans la disposition ou l'étalonnage de leurs zones sensibles au champ magnétique au passage à zéro du champ magnétique, les signaux de départ des systèmes de mesure de champ magnétique correspondant étant reliés entre eux par des opérations mathématiques de manière que les parties parasites soient réduites au minimum.

14. Dispositif selon la revendication 13, **caractérisé en ce que** la disposition des appareils de mesure de champ absolu (1) ou gradiomètres (1) se compose d'un nombre impair d'appareils de mesure de champ absolu (1) ou gradiomètre (1) identique ou analogue dans la zone du passage à zéro.

15. Dispositif selon la revendication 13, **caractérisé en ce que** la disposition se compose de gradiomètres (1) ou d'appareils de mesure de champ absolu (1) différents ou calibrés de façon différente.

16. Dispositif selon la revendication 13, **caractérisé en ce que** la disposition est formée en disposition asymétrique de gradiomètres symétriques (1) ou en dispositions d'appareils de mesure de champ absolu (1) par rapport au passage à zéro du champ magnétique.

17. Dispositif selon la revendication 1, **caractérisé en ce que** le conducteur (3) est entouré entièrement ou partiellement d'un matériau (16, 17) approprié pour conduire le flux magnétique.

18. Dispositif selon la revendication 1, **caractérisé en ce que** le conducteur (3) est façonné dans la direction du flux de courant asymétriquement par rapport à la ou aux évidements (8, 9) pour une optimisation du gradient de champ magnétique.

19. Dispositif selon la revendication 1, **caractérisé en ce que** le gradiomètre (1) au moins présent ou la disposition d'appareils de mesure de champ absolu (1) est fixé sur au moins un support (10) par des moyens techniques de microsystèmes et est positionné avec le support (10) au moins présent dans au moins un évidement (8, 9) ou son environnement.

20. Dispositif selon la revendication 1, **caractérisé en ce que** le ou les systèmes de mesure de champ magnétique ou de gradient de champ magnétique (1) est formé de systèmes de mesure de champ magnétique ou de gradients de champs magnétiques (1) fonctionnant sur la base de l'effet Hall.

21. Dispositif selon la revendication 20, **caractérisé en ce que** le ou les systèmes de mesure de champ magnétique ou de gradient de champ magnétique (1) est ou sont formés en plaques de champ ou en capteurs Hall intégrés de façon verticale ou cylindrique.

22. Dispositif selon la revendication 20, **caractérisé en ce que** le dispositif présente des concentrateurs de flux intégrés par une technique de microsystèmes.

23. Dispositif selon la revendication 20, **caractérisé en ce que** le ou les systèmes de mesure de champ magnétique ou de gradient de champ magnétique (1) contient ou contiennent des zones magnétiquement sensibles qui sont fabriquées en utilisant des matériaux semi-conducteurs IV ou III-V par des procédés standard de fabrication de semi-conducteurs, comme la technologie bipolaire, CMOS ou BICMOS.

24. Dispositif selon la revendication 1, **caractérisé en ce que** le ou les systèmes de mesure de champ magnétique ou de gradient de champ magnétique (1) fonctionnent à base d'effet anisotrope, de gigantisme, colossal ou autre effet magnétorésistif (AMR, GMR, CMR).

25. Dispositif selon la revendication 1, **caractérisé en ce que** le ou les systèmes de mesure de champ magnétique ou de gradient de champ magnétique (1) sont formés en systèmes de mesure de champ magnétique ou de gradient de champ magnétique (1) utilisant le principe de transformateur.

26. Dispositif selon la revendication 1, **caractérisé en ce que** le ou les systèmes de mesure de champ magnétique ou de gradient de champ magnétique (1) sont formés en systèmes de mesure de champ magnétique ou de gradient de champ magnétique (1) fonctionnant sur la base de l'effet Josephson.

27. Dispositif selon l'une des revendications 20 à 26, **caractérisé en ce que** le ou les systèmes de mesure des champs magnétiques ou de gradients de champs magnétiques (1) sont formés en systèmes de mesure de champ magnétique ou de gradients de champ magnétique (1) fonctionnant sur une combinaison de principes ou d'effets.

28. Dispositif selon la revendication 1, **caractérisé en ce que** le dispositif est formé en dispositif déterminant des grandeurs que l'on peut dériver de courants.

29. Dispositif selon la revendication 1, **caractérisé en ce qu'**au moins une partie du dispositif est blindée contre les champs électromagnétiques parasites externes.

30. Dispositif selon la revendication 1, **caractérisé en ce que** le dispositif est formé en dispositifs utilisant les signaux de départ des systèmes de mesure de champ magnétique ou de gradients de champs magnétiques (1) pour la détection de surintensités.

31. Dispositif selon la revendication 1, **caractérisé en ce que** le dispositif est formé en unités de mesure de courant sans potentiel et présente des conducteurs qui peuvent être connectés aux conducteurs de courant conduisant le courant à mesurer.

32. Dispositif selon la revendication 1, **caractérisé en ce que** le conducteur formant gradient (3) est fixé en tant que partie de l'appareil cible ou y est contenu, et **en ce que** le dispositif de mesure du gradient est disposé sous une forme préfixée dans l'environnement des évidements (8, 9).

33. Dispositif selon la revendication 1, **caractérisé en ce que** le dispositif est forme en un dispositif reliant mathématiquement entre eux lors de l'évaluation, dans la mesure de courants de grande intensité, les valeurs mesurées de différents systèmes de gradients magnétiques (1) qui sont prises dans les évidements (8, 9) d'un conducteur (3) ou dans l'environnement de divers évidements (8, 9) d'un conducteur (3), de manière que les parties parasites soient réduites au minimum ou éliminées.

34. Procédé de mesure de courant sans potentiel à l'aide d'un dispositif selon l'une des revendications 1 à 33 par l'enregistrement du champ magnétique produit par le courant primaire en question dans un conducteur (3) ou de son gradient, où l'on mesure le champ magnétique ou son gradient, le conducteur (3) étant muni d'au moins un évidement (8, 9), et la mesure du champ magnétique ou de son gradient étant toujours réalisée dans l'environnement des divers évidements (8, 9).

35. Procédé selon la revendication 34, **caractérisé en ce qu'**on procède à la mesure du gradient de champ magnétique ou du champ magnétique d'un conducteur de courant (3) qui se compose de plusieurs pièces (12, 13), au moins un évidement (8, 9) étant formé par la disposition des pièces (12, 13).
